# EUROPEAN PATENT SPECIFICATION

(11) **EP 2 830 404 B1**
(45) Date of publication and mention of the grant of the patent: **06.11.2019**
(21) Application number: 14175918.3
(22) Date of filing: 07.07.2014
(51) Int. Cl.: H05K 7/20, F24F 7/007, H05K 1/02

(54) **Cooling device**
Kühlvorrichtung
Dispositif de refroidissement

(30) Priority: 22.07.2013 KR 20130086119
(43) Date of publication of application: 28.01.2015
(73) Proprietor: LSIS Co., Ltd., Anyang-si, Gyeonggi-do 431-080 (KR)
(72) Inventor: Kwon, Hyuk Il, Gunpo-si, Gyeonggi-do 435-020 (KR)
(74) Representative: K&L Gates LLP

(56) References cited:
- DE-U1- 9 111 434
- JP-A- 2011 249 495
- US-A1- 2010 039 771

## Description

### BACKGROUND OF THE INVENTION

### Field of the invention

The teachings in accordance with the exemplary embodiments of this present disclosure generally relate to a cooling device.

### Description of Related Art

Generally, industrial electronic products or home electronic appliances are mounted with heat generating elements that generate a large amount of heat. For example, an inverter configured to convert a DC (Direct Current) to an AC (Alternating Current) generates a large amount of heat from a power semiconductor and peripherals thereof.

The inverter is mounted with a heat sink for cooling a power semiconductor, where a forced cooling method using a cooling fan is used for the heat sink while a natural cooling method is used for peripherals that generate heat. However, the peripherals may be over-heated to decrease performance of the product or damage the product, when the natural cooling method is used to cool the peripherals.

DE 91 11 434 U1 discloses means for heat transport from vessels such as electrical cabinets which includes heat-emitting devices, for example, electronic power and / or electronic functional groups. The vessel is divided by partition into at least two spaces with different degrees of protection circuit ventilated of which the one and the other is provided with a heat exchanger or a reefer.

JP 2011 249495 A discloses a cooling device according to the preamble of claim 1.

### SUMMARY OF THE DISCLOSURE

An exemplary embodiment of the present disclosure is to provide a cooling device configured in such a manner that a heat generating unit arranged in an open space and coupled to a heat radiating member like a heat sink is forcibly cooled using an outside air, and a heat generating unit arranged in a closed space and not coupled to a heat sink is forcibly cooled using circulation of inside air, whereby a cooling efficiency of the heat generating unit can be enhanced.

Technical subjects to be solved by the present disclosure are not restricted to the above-mentioned problems, and any other technical problems not mentioned so far will be clearly appreciated from the following description by a person skilled in the art.

In one general aspect of the present disclosure, there is provided a cooling device comprising the features of independent claim 1.

Preferably, but not necessarily, the cooling device may further comprise a circuit substrate arranged at an upper surface of the separator to be coupled to the first heat generating unit.

### Advantageous Effects of the Disclosure

The cooling device according to an exemplary embodiment of the present disclosure has an advantageous effect in that a heat generating unit arranged in an open space and coupled to a heat radiating member like a heat sink is forcibly cooled using a outside air, and a heat generating unit arranged in a closed space and not coupled to a heat sink is forcibly cooled using circulation of inside air.

### Brief Description of Drawings

FIG. 1 is a cross-sectional view illustrating a cooling device according to an exemplary embodiment not being part of the invention but useful for understanding the invention.
FIG. 2 is a plan view illustrating a circulation fan and a support plate of FIG. 1.
FIG. 3 is a cross-sectional view illustrating a cooling device according to the invention.

### Detailed Description of the Disclosure

A cooling device according to exemplary embodiments of the present disclosure will be described more fully hereinafter with reference to the accompanying drawings.

Detailed descriptions of well-known functions, configurations or constructions are omitted for brevity and clarity so as not to obscure the description of the present disclosure with unnecessary detail. In the drawings, the width, length, thickness, etc. of components may be exaggerated or reduced for the sake of convenience. The present inventive concept may, however, be embodied in many different forms and should not be construed as limited to the example embodiments set forth herein. Rather, the described aspect is intended to embrace all such alterations, modifications, and variations that fall within the scope and novel idea of the present disclosure.

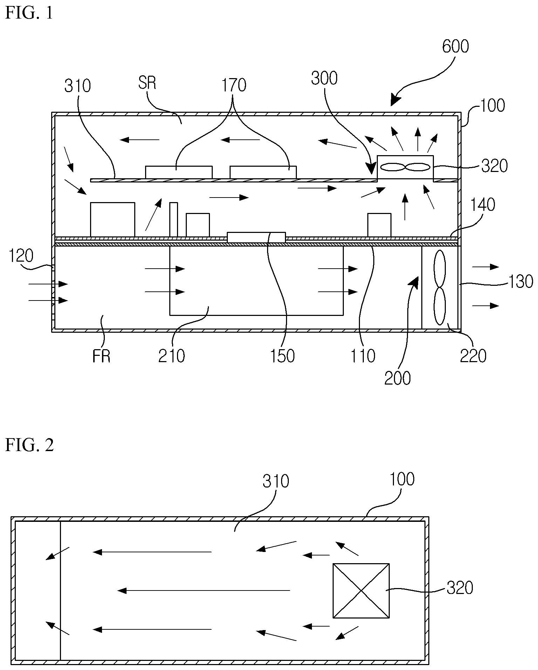

FIG. 1 is a cross-sectional view illustrating a cooling device according to an exemplary embodiment useful for understanding the invention. and FIG. 2 is a plan view illustrating a circulation fan and a support plate of FIG. 1.

Referring to FIGS. 1 and 2, the cooling device (600) includes a case (100), a first cooling unit (200) and a second cooling unit (300). The cooling device (600) according to an exemplary embodiment of the present disclosure may be widely installed on an industrial electronic products or home electronic appliances. Now, the explanation of the cooling device (600) is provided on an assumption that the cooling device (600) is installed on an inverter, as an industrial electronic product, that changes a DC to an AC having a frequency and a voltage that require a commercial AC power.

The case (100) provides a space for accommodating devices for implementing an inerter operation and the first/second cooling units (200, 300). The case (100) in the exemplary embodiment of the present disclosure may be divided into two spaces, for example. Hereinafter, the two spaces are defined as a first region (FR) and a second region (SR) separated from the first region (FR), where the first region (FR) is an open space and the second region (SR) is a closed space.

In order to form two spaces inside the case (100), the case (100) is formed with a separator configured to separate the first region from the second region. The separator (110) is arranged at a center of the case (100), and the case (100) is divided into two sections, that is the first region (FR) and the second region (SR).

The second region (SR) is arranged at an upper surface of the first region (FR) by the separator (110), and a part of the separator (110) is formed with an opening, where the opening formed by the separator (110) allows a first heat generating unit arranged at the second region (SR) to be coupled to a heat sink arranged at the first region (FR).

In the exemplary embodiment, openings (120, 130) configured to introduce an outside air to and discharge the outside air from the first region (FR) are formed at an area corresponding to the first region (FR) of the case (100), where the second region (SR) is air-tightly closed to prevent entrance of foreign objects such as dust and the like.

Meantime, an upper surface of the separator (110) dividing an interior of the case (100) into the first and second regions (FR, SR) is arranged with a circuit substrate (140). The circuit substrate (140) is formed at an upper surface with a first heat generating unit (150), where the circuit substrate (140) and the first heat generating unit (15) are electrically connected.

In the exemplary embodiment, the first heat generating unit (150) may include a power semiconductor, and the first heat generating unit (150) may include an IGBT (Insulated Gate Bipolar Transistor), for example. Alternatively, the first heat generating unit (150) may include MOSFET (Metal Oxide Semiconductor Field Effect Transistor).

The first cooling unit (200) serves to cool the first heat generating unit (150). In the exemplary embodiment of the present disclosure, the first cooling unit (200) may be arranged at the first region (FR). The first cooling unit (200) arranged at the first region (FR) may include a heat sink (210) and a cooling fan (220).

The heat sink (210) may include aluminum or aluminum alloy having a higher heat conductivity than iron, and the heat sink (210) is coupled to the first heat generating unit (150) electrically connected to the circuit substrate (140) and radiates heat generated from the first heat generating unit (150) to the first region (FR).

The cooling fan (220) is arranged at the first region (FR), and the cooling fan (220) is arranged near to the opening (130) formed at the first region (FR). The cooling fan (220) serves to discharge an outside air to outside of the first region (FR). At this time, the outside air is introduced into the first region (FR) and heated via the heat sink (210). The outside air introduced into the first region (FR) by the cooling fan (220) serves to cool the heat sink (210), whereby the first heat generating unit (150) coupled to the heat sink (210) is forcibly cooled by the cooling fan (220).

The second cooling unit (300) may be arranged at the second region (SR) in order to cool the second heat generating unit (170) arranged at the second region (SR). In the exemplary embodiment of the present disclosure, the second heat generating unit (170) may include a circuit substrate and at least one control module including control semiconductor chips, for example.

The second cooling unit (300) cools the second heat generating unit (170) by circulating an inside air circulating in the second heat generating unit (170) arranged at the closed second region (SR). The second cooling unit (300) may include a support plate (310) and a circulation fan (320) in order to cool the heat generating unit (170) in a circulation cooling method.

The support plate (310) is arranged at the second region (SR), and the support plate (310) is secured at a position distanced from the separator (110), an opening is formed at one side of the support plate (310) and the circulation fan (320, described later) is arranged at a position corresponding to the opening. The support plate (310) may be arranged in parallel with the separator (110), a distal end of the support plate (310) may be distanced from the case, and the separator (110) may be formed with the second heat generating unit (170).

The circulation fan (320) may be coupled to the support plate (31), the circulation fan (320) may be arranged at a position corresponding to the opening of the support plate (310), and the circulation fan (320) may be arranged in parallel with the support plate (310) and the separator (110).

The inside air of the second region (SR) is circulated by operation of the circulation fan (320), because a distal end of the support plat (310) is distanced from the case (100) and the opening formed at the support plate (310) is coupled to the circulation fan (320).

In the exemplary embodiment, the first region (FR) arranged with the heat sink (210) is performed with a forcible cooling of the first heat generating unit (150) using an outside air by the cooling fan (220), and the closed second region (SR) is performed with the circulatory cooling of the second heat generating unit (170) by the inside air circulated by the circulation fan (320), whereby cooling efficiency of the first and second heat generating units (150, 170) can be further enhanced.

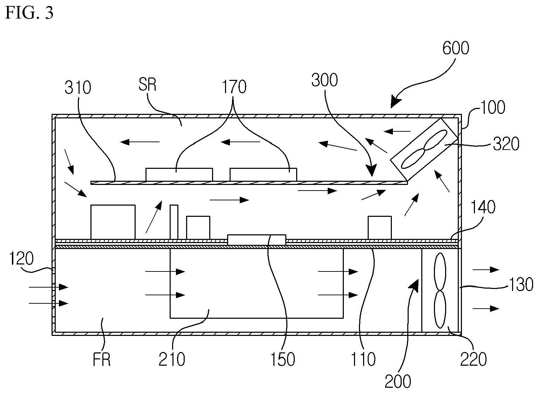

FIG. 3 is a cross-sectional view illustrating a cooling device according to the invention.

The configuration of the cooling device is substantially same as that of FIGS. 1 and 2 except for arrangement of circulation fan. Thus, no redundant explanation on the same structure will be omitted, and, like reference numerals in FIG. 3 denote like elements.

Referring to FIG.3, the circulation fan (320) is slantly arranged and is arranged to a slant direction relative to the support plate (310) in order to better circulate the inside air of the second region (SR), whereby the inside air of the second region (SR) can be more actively circulated by the circulation fan (320).

As apparent from the foregoing, a heat generating unit arranged at an opened space and coupled to heat radiating members like a heat sink is forcibly cooled using an outside air, and a heat generating unit arranged at a closed space and not coupled to the heat sink is forcibly cooled by circulation of inside air, whereby the cooling efficiency of heat units can be further enhanced by forced cooling.

Although the present disclosure has been described in detail with reference to the foregoing embodiments and advantages, many alternatives, modifications, and variations will be apparent to those skilled in the art within the scope of the claims. Therefore, it should be understood that the above-described embodiments are not limited by any of the details of the foregoing description, unless otherwise specified, but rather should be construed within the scope as defined in the appended claims

## Claims

1. A cooling device installed on an inverter, as an industrial electronic product, that changes a DC to an AC having a frequency and a voltage that require a commercial AC power, the cooling device comprising:
a case (100) including a first region (FR) that is partially opened to an outside, and a second region (SR) that is closed to the outside and separated from the first region (FR), in an integrated space;
a first cooling unit (200) arranged at the first region (FR) to cool a first heat generating unit (150) using an outside air;
wherein the case (100) includes a separator (110) that completely separates the first region (FR) and the second region (SR) in the case (100),
wherein the first cooling unit (200) includes a heat sink (210) coupled to the first heat generating unit (150) and a cooling fan (220) configured to introduce the outside air to the first region (FR), and
wherein a part of the separator (110) is formed with an opening, where the opening formed by the separator (110) allows the first heat generating unit (150) arranged in the second region (SR) to be coupled to the heat sink (210) arranged in the first region (FR);
**characterized by** a second cooling unit (300) arranged at the second region (SR) to cool a second heat generating unit (170) using inside air;
wherein the second cooling unit (300) includes a support plate (310) configured to support the second heat generating unit (170) and a circulation fan (320) configured to circulate the inside air in the second region (SR);
wherein the circulation fan (320) is slantly arranged relative to the support plate (310); and wherein at least one distal end of one side of the support plate (310) is distanced from a lateral surface plate of the case (100), and the support plate (310) is formed with an opening coupled to the circulation fan (320).

2. The cooling device of claim 1, further comprising a circuit substrate (140) arranged at an upper surface of the separator (110) to be coupled to the first heat generating unit (150).

## Patentansprüche

1. Ein in einem Wechselrichter installiertes Kühlgerät als industrielles elektronisches Produkt, das einen Gleichstrom in einen Wechselstrom mit einer Frequenz und einer Spannung umwandelt, die eine kommerzielle Wechselstromversorgung erfordern, die Kühleinrichtung umfassend:
ein Gehäuse (100) mit einem ersten Bereich (FR), der teilweise nach außen geöffnet ist, und einem zweiten Bereich (SR), der nach außen geschlossen und vom ersten Bereich (FR) getrennt ist, in einem integrierten Raum;
eine erste Kühleinheit (200), die in dem ersten Bereich (FR) angeordnet ist, um eine erste Wärmeerzeugungseinheit (150) unter Verwendung einer Außenluft zu kühlen;
wobei das Gehäuse (100) einen Abscheider (110) enthält, der den ersten Bereich (FR) und den zweiten Bereich (SR) in dem Gehäuse (100) vollständig trennt,
wobei die erste Kühleinheit (200) eine Wärmesenke (210), die mit der ersten Wärmeerzeugungseinheit (150) gekoppelt ist, und einen Kühllüfter (220) umfasst, der konfiguriert ist, um die Außenluft in den ersten Bereich (FR) einzuleiten, und
wobei ein Teil des Abscheiders (110) mit einer Öffnung ausgebildet ist, wobei die durch den Abscheider (110) gebildete Öffnung es ermöglicht, dass die im zweiten Bereich (SR) angeordnete erste Wärmeerzeugungseinheit (150) mit dem im ersten Bereich (FR) angeordneten Wärmesenke (210) gekoppelt wird;
**gekennzeichnet durch** eine zweite Kühleinheit (300), die in dem zweiten Bereich (SR) angeordnet ist, um eine zweite Wärmeerzeugungseinheit (170) unter Verwendung von Innenluft zu kühlen;
wobei die zweite Kühleinheit (300) eine Tragplatte (310), die zum Tragen der zweiten Wärmeerzeugungseinheit (170) konfiguriert ist, und einen Umwälzventilator (320) umfasst, der zum Umwälzen der Innenluft in dem zweiten Bereich (SR) konfiguriert ist;
wobei das Zirkulationsgebläse (320) relativ zu der Trägerplatte (310) schräg angeordnet ist; und wobei mindestens ein distales Ende einer Seite der Tragplatte (310) von einer Seitenflächenplatte des Gehäuses (100) beabstandet ist und die Tragplatte (310) mit einer mit dem Zirkulationsgebläse (320) gekoppelten Öffnung ausgebildet ist.

2. Kühlvorrichtung nach Anspruch 1, ferner umfassend ein Schaltungssubstrat (140), das an einer oberen Oberfläche des Abscheiders (110) angeordnet ist, um mit der ersten Wärmeerzeugungseinheit (150) gekoppelt zu werden.

## Revendications

1. Dispositif de refroidissement installé sur un onduleur, en tant que produit électronique industriel, qui change un CC en CA ayant une fréquence et une tension qui nécessitent une électricité CA commerciale, le dispositif de refroidissement comprenant :
un boîtier (100) comprenant une première région (FR) qui est partiellement ouverte sur un extérieur, et une deuxième région (SR) qui est fermée à l'extérieur et séparée de la première région (FR), dans un espace intégré ;
une première unité de refroidissement (200) agencée au niveau de la première région (FR) pour refroidir une première unité de génération de chaleur (150) en utilisant un air extérieur ;
dans lequel le boîtier (100) comprend un séparateur (110) qui sépare complètement la première région (FR) et la deuxième région (SR) dans le boîtier (100),
dans lequel la première unité de refroidissement (200) comprend un dissipateur de chaleur (210) couplé à la première unité de génération de chaleur (150) et un ventilateur de refroidissement (220) conçu pour introduire l'air extérieur dans la première région (FR),
dans lequel une partie du séparateur (110) est formée avec une ouverture, l'ouverture formée par le séparateur (110) permettant le couplage de la première unité de génération de chaleur (150) agencée dans la deuxième région (SR) au dissipateur de chaleur (210) agencé dans la première région (FR) ;
**caractérisé par** une deuxième unité de refroidissement (300) agencée au niveau de la deuxième région (SR) pour refroidir une deuxième unité de génération de chaleur (170) en utilisant l'air intérieur ;
dans lequel la deuxième unité de génération de chaleur (300) comprend une plaque de support (310) conçue pour supporter la deuxième unité de génération de chaleur (170) et un ventilateur de circulation (320) conçu pour faire circuler l'air intérieur dans la deuxième région (SR) ;
dans lequel le ventilateur de circulation (320) est agencé de manière inclinée par rapport à la plaque de support (310) ; et dans lequel au moins une extrémité distale d'un côté de la plaque de support (310) est mise à distance d'une plaque de surface latérale du boîtier (100), et la plaque de support (310) est formée avec une ouverture couplée au ventilateur de circulation (320).

2. Dispositif de refroidissement selon la revendication 1, comprenant en outre un substrat de circuit (140) agencé au niveau d'une surface supérieure du séparateur (110) pour être couplé à la première unité de génération de chaleur (150).
